Europäisches Patentamt

European Patent Office

Office européen des brevets

(11) Publication number: **0 146 613**
**B1**

(12) **EUROPEAN PATENT SPECIFICATION**

(45) Date of publication of patent specification: **05.12.90**

(51) Int. Cl.⁵: **H 01 L 21/285, H 01 L 21/308**

(21) Application number: **84902421.1**

(22) Date of filing: **07.06.84**

(86) International application number:
**PCT/US84/00877**

(87) International publication number:
**WO 84/04996 20.12.84 Gazette 84/30**

(54) **PROCESS FOR FABRICATING SEMICONDUCTOR STRUCTURES.**

(30) Priority: **13.06.83 US 503997**

(43) Date of publication of application:
**03.07.85 Bulletin 85/27**

(45) Publication of the grant of the patent:
**05.12.90 Bulletin 90/49**

(84) Designated Contracting States:
**DE GB NL**

(73) Proprietor: **NCR CORPORATION**
**World Headquarters**
**Dayton, Ohio 45479 (US)**

(72) Inventor: **SOBCZAK, Zbigniew, Paul**
**1225 Half Circle Lane**
**Colorado Springs, CO 80915 (US)**

(74) Representative: **Robinson, Robert George**
**International Patent Department NCR Limited**
**206 Marylebone Road**
**London NW1 6LY (GB)**

(56) References cited:
**EP-A-0 098 374**
**US-A-4 025 411**
**US-A-4 307 180**
**US-A-4 361 600**
**US-A-4 361 600**
**US-A-4 407 851**

**IBM TECHNICAL DISCLOSURE BULLETIN, vol.
24, no. 7B, December 1981, pages 3689-3690,
New York, US; V.J. SILVESTRI: "Silicon-silicon
dioxide-silicon structures"**

(56) References cited:
**IBM TECHNICAL DISCLOSURE BULLETIN, vol.
25, no. 11B, April 1983, pages 6129-6130, New
York, US; P.J. TSANG: "Forming wide trench
dielectric isolation"**

**TECHNICAL DISCLOSURE BULLETIN vol.24, no.
11B issued April 1982, B.M. Kemlage and J.S.
Lechaton and J.L. Mauer:"TOTAL DIELECTRIC
ISOLATION" pages 6008-6009**

# Description

Technical field

This invention relates to a process for fabricating silicon-on-insulator structures on a semiconductor wafer.

Background art

Processes suitable to form silicon-on-insulator (SOI) structures have been the subject of extensive investigation in recent years. The same situation exists for planarization techniques suitable to eliminate or substantially reduce the step coverage problems attributable to recessed isolation or multilevel structures in semiconductor chips. The approaches derived have, however, had limited general acceptance by virtue of their cost, the additional process complexity, or their degrading effect on active device performance.

U.S. Patent No. 4,361,600 discloses a process for forming electrically isolated silicon islands on a semiconductor wafer. This known process includes forming a silicon mesa structure supported on silicon and oxidizing the mesa structure with the surfaces of the mesa completely covered with silicon nitride. Though the known process provides a method of forming electrically isolated islands of monocrystalline silicon, the process is constrained by the lateral oxidation characteristics of silicon structure employed to applications involving relatively narrow island dimensions and relatively wide island-to-island separations. Thus, in the known process, when the silicon substrate is oxidized the silicon dioxide must first be grown downward before it can progress laterally underneath the mesa. The specialized processing required to effectively diffuse oxygen this additional distance is an admitted deficiency of the known process.

U.S. Patent No. 4,407,851 discloses a method of forming a flat field region in a semiconductor substrate, including the steps of forming a recess in the substrate, forming a CVD oxide layer over the entire surface, selectively removing the oxide layer to form a V-shaped groove between the side of the recess and the first insulating layer, and filling the V-shaped groove with a second CVD oxide layer, followed by the deposition of a resist film. The entire surface of the structure is then etched by reactive ion etching. The etching rates of the resist film and the second CVD oxide layer can be made to be substantially the same.

From IBM Technical Disclosure Bulletin, vol. 24, No. 11B, April 1982, B. M. Kemlage et al, "Total Dielectric Isolation", pages 6008—6009, there is known a process of forming areas of silicon which are fully dielectrically isolated from the substrate. A silicon dioxide masking layer is deposited and lithographically shaped, whereafter trenches are etched into the substrate. Next, an oxide formation and RIE procedure is utilized to form sidewall material with the bottoms of the trenches being opened to the silicon substrate. The wafer is then etched in an anisotropic etchant such as pyrocatechol or KOH solution so that the separated silicon areas are undercut. Then, thermal oxidation is performed to isolate the silicon areas from the substrate while sealing and closing the openings under the silicon areas. Next, a second set of trenches is opened lithographically, to join the first set together and complete the isolation. Using another RIE step, these trenches are etched down to the underlying oxide and all trenches are refilled by standard process, thereby providing areas of silicon which are fully isolated by oxide from the substrate as well as from each other.

US—A—4 307 180 discloses a method for fabricating a semiconductor device, wherein deep dielectric isolation regions are provided, and excess dielectric material removed to restore surface planarity. Thus, trenches are first formed by reactive ion etching. Next silicon dioxide material is deposited by a CVD technique to fill the trenches and extend over the adjacent substrate surface. Then, a layer of polymer or resist material is flowed over the surface to fill any remaining depressions and provide a planar surface. Finally an RIE step, which etches silicon, silicon dioxide and the polymer layer at substantially the same rate is employed to provide a planarized surface at the desired level.

Disclosure of the invention

According to the present invention, there is provided a process for fabricating silicon-on-insulator structures on a semiconductor wafer, including the sequential steps of: anisotropically etching into a silicon substrate to form islands of silicon; capping the tops and sides of the silicon islands with masks; anisotropically etching deeper into the silicon substrate between the capped silicon islands to increase the relative height of the silicon islands; and oxidizing exposed silicon not covered by said masks until the capped silicon islands are electrically isolated from the silicon substrate thereby forming electrically isolated silicon islands. In a preferred embodiment of the invention, the process is continued by depositing a dielectric layer over and between the electrically isolated silicon islands to a thickness greater than the height of the electrically isolated silicon islands; forming a planarized polymer layer over the dielectric layer; simultaneous etching the polymer and dielectric layers to remove polymer and dielectric material at substantially equal rates until the polymer layer is absent; and simultaneously etching the dielectric layer and the electrically isolated silicon to remove dielectric material and silicon at substantially equal rates.

It will be appreciated that a process according to the first aspect of the invention alleviates the dimensional restriction problem of the process of U.S. Patent No. 4,361,600 while providing the coplanar wafer topology commonly sought. The benefits are attained by etching the monocrystalline silicon substrate at an appropriate stage in the process to effectively elevate the capped island region of silicon before oxidizing the exposed silicon. To reduce the topological excursions of the mesa-shaped structure formed in the manner of the present process, the wafer is also subjected to a sequence of planarization steps in the course of leveling the active surface for conventional fabrication of active devices and electrical interconnects. In this way, the uneven topology produced by the earlier steps of fabrication is fully planarized during the latter steps in the process.

These process features produce structures having excellent line width control between the island perimeters as defined by the fabrication masks and the silicon island perimeters actually formed. This result is attributable to the absence of any oxidation at the upper surfaces of the islands.

As a further consideration, it should be understood and appreciated that a coplanar relationship between the silicon islands and the surrounding dielectric is particularly important with the increasing utilization of anisotropic etching to form the gate electrodes of semiconductor devices, most commonly field effect transistors. If the silicon islands are allowed to protrude above the surrounding dielectric, an anisotropic etch of the gate electrode material will leave narrow filaments of the gate electrode material at the perimeters of the islands. Any such electrode material residuals create electrical shorting paths at the perimeters of the islands.

When used to fabricate integrated circuits from monocrystalline silicon substrates the embodied process provides the capability of forming silicon islands which have precisely defined perimeter lines and are situated in close proximity to each other, without degrading the original quality of the crystalline silicon substrate material.

In one form of its practice, the invention commences with an anisotropic etch of a photoresist masked wafer having a monocrystalline silicon substrate covered in ascending order with a PAD silicon dioxide (PAD oxide) layer, a silicon nitride (nitride) layer, and a thicker oxide layer. The etching is continued until island-like structures of substrate silicon are formed. Thereafter, a brief oxidation is followed with a nitride layer deposition and an anisotropic nitride etch operation. Upon the conclusion of the nitride etch, the silicon islands are capped using nitride on the walls and a nitride/oxide composite layer on the top plateau.

During the next stage of fabrication, the capped silicon islands are subjected to another anisotropic silicon etch, suitable to remove further substrate and effectively elevate the relative height of the capped regions. The thermal oxidation step which follows is continued until the laterally exposed silicon regions beneath the now-elevated capped islands are completely oxidized to form dielectrically isolated islands of monocrystalline silicon over dielectric. The nitride cap protects the silicon islands from the oxidation ambient. The nitride and oxide capping materials are then stripped to expose the monocrystalline silicon islands for further processing.

The island structures formed during these initial steps of fabrication are then covered with a layer of chemical vapor deposited oxide to a thickness greater than the level of the island plateaus. The oxide deposition is followed with the deposition of one or more polymer layers to planarize the wafer topology. The preferred polymer is characterized by a low viscosity and a low surface tension when in the molten state.

The polymer coated wafer is then subjected to a first etch sequence, during which the etchant composition is adjusted to maintain an equal etch rate for the polymer and immediately underlying oxide. Thereby, the undulations in the oxide are removed concurrently with the polymer layer. At the conclusion of the polymer/oxide etch sequence, the silicon islands remain masked with thin layers of oxide. To remove the oxide and expose the silicon island surface, another etch is undertaken, this time performed with etchants which remove oxide and silicon at substantially the same rate. When all the oxide over the silicon islands has been removed, etching is terminated.

As presently embodied, the completed structure is comprised of high quality monocrystalline silicon islands isolated by, and lying coplanar with, surrounding regions of dielectric material.

Brief description of the drawings

One embodiment of the present invention will now be described by way of example with reference to the accompanying drawings, in which:

Fig. 1 is a schematic cross-section of the substrate and covering layers masked by patterned photoresist to define the locations of the islands.

Fig. 2 is a schematic cross-section after the initial etching of the island structure and a nitride deposition.

Fig. 3 illustrates the shape after an anisotropic etch of the nitride.

Fig. 4 shows the region after anisotropic etching of the substrate silicon.

Fig. 5 shows the effects of thermal oxidation.

Fig. 6 illustrates the shape of the structure after the deposition of planarizing oxide and polymer.

Fig. 7 shows the effects of a polymer/oxide etch.

Fig. 8 depicts the final structure, at the conclusion of the oxide/silicon etch.

Best mode for carrying out the invention

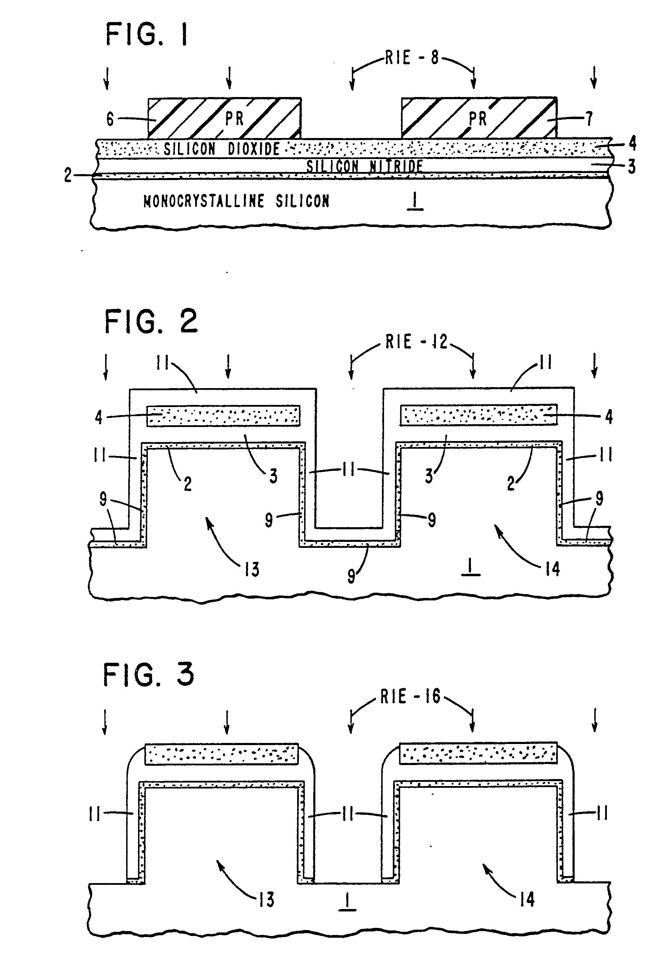

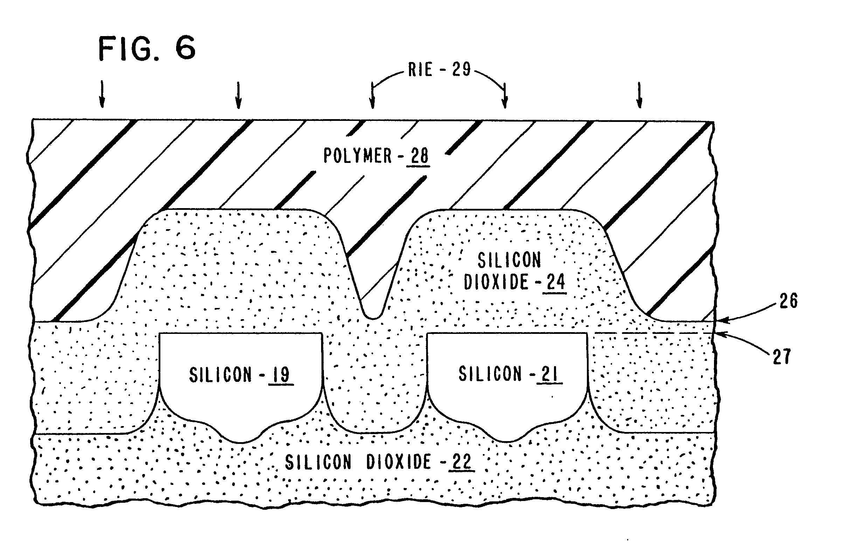

A review of the drawings illustrating an embodiment of the present invention will disclose that the composite process consists of two generally distinguishable sequences. The first sequence, encompassing Figs. 1—5, forms the silicon islands, while the second sequence, encompassing Figs. 6—8, planarizes the islands and surrounding dielectric. Though each segment incorporates novel features in its own right, the unique combination provides a composite process in which the latter steps complement the structural effects of the earlier steps. To more fully appreciate the various facets of the process, consider the preferred embodiment as described hereinafter.

The schematic cross-section depicted in Fig. 1 shows monocrystalline silicon (silicon) substrate 1 covered with a nominal 30 nanometers of thermally grown PAD oxide layer 2, and a nominal 150 nanometers nitride layer 3. Any commonly employed process may be utilized to form layers 2 and 3. Nitride layer 3 is further covered with a nominal 200 nanometer thick layer of plasma enhanced chemical vapor deposited (CVD) oxide 4. Oxide layer 4 will serve as a shield during the subsequent application of reactive ion etching (RIE) to remove nitride and silicon.

A photoresist (PR) is then deposited and photolithographically processed to retain PR segments 6 and 7, as shown in Fig. 1. Each PR segment defines a location of the island to be formed beneath. The nominal width of each PR segment preferably lies between one and two micrometers, whereas the separation between PR segments 6 and 7 is preferably at least one micrometer.

With the photoresist mask in place, the wafer is subjected to RIE 8, for removing oxide 4, nitride 3, oxide 2 and silicon 1, until silicon 1 has been etched a nominal one micrometer in depth. This etch can be performed in an Applied Materials AM-8110 RIE reactor. The nominal etching conditions are presented in Table A for the oxide and nitride layers.

TABLE A

Gas and flow: $CHF_3$ at 75 cm$^3$/min
+$O_2$ at 5 cm$^3$/min.
Pressure: 8.6 Pa (65 mTorr).
Power: 1,200 Watts.

|  | $SiO_2$ | $Si_3N_4$ | Standard PR |
|---|---|---|---|
| Etch rate | 45 nm/min | 40 nm/min | 7 nm/min |

The etching of silicon 1 with RIE 8 utilizes the conditions prescribed in Table B.

TABLE B

Gas and flow: $NF_3$ at 20 cm$^3$/min.
Pressure: 5.3 Pa (40 mTorr).
Power: 450 Watts.

|  | Si | Standard PR |
|---|---|---|
| Etch rate | 40 nm/min | 15 nm/min |

In progressing to the structure depicted in Fig. 2, the wafer is next thermally oxidized to grow a nominal 30 nanometers of new PAD oxide 9 on any exposed silicon 1. Thereafter, a nominal 150 nanometers of low pressure CVD nitride 11 is formed on the semiconductor wafer. The nitride layer will protect the sidewalls of the silicon island from direct thermal oxidation. The concluding structure has the general appearance of the composite in Fig. 2.

The succeeding step in the process is comprised of RIE 12, to anisotropically remove at least 150 nanometers of nitride and 30 nanometers of PAD oxide without exposing the top or sidewalls of the silicon islands at locations 13 and 14. This etch can be performed in the same reactor under the conditions recited in Table C.

TABLE C

Gas and flow: $NF_3$ at 20 cm$^3$/min.
Pressure: 5.3 Pa (40 mTorr).
Power: 900 Watts.

Etch Rate: 70—80 nanometers per minute for $Si_3N_4$.

The structure produced is depicted in Fig. 3. Note that nitride sidewalls 11 remain substantially intact because of the anisotropic etch characteristics.

Notwithstanding the former practice in the art, the present process now prescribes the application of another RIE, 16, to the structure in Fig. 3. As presently embodied, anisotropic etching of substrate silicon 1 is continued until an additional layer of silicon, 1—2 micrometers thick, is removed. Note that the depth of the additional etch is proportional to the width of the islands established earlier by PR masks 6 and 7. RIE 16 is preferably performed with a Drytek DRIE-100 reactor according to the conditions prescribed in Table D.

TABLE D

Gas and flow: $CF_3Cl$ at 75 cm$^3$/min.
Pressure: 26.7 Pa (0.2 Torr).
Power: 700 Watts.

|  | Si | $SiO_2$ |
|---|---|---|
| Etch rate | 50 nm/min | 5 nm/min |

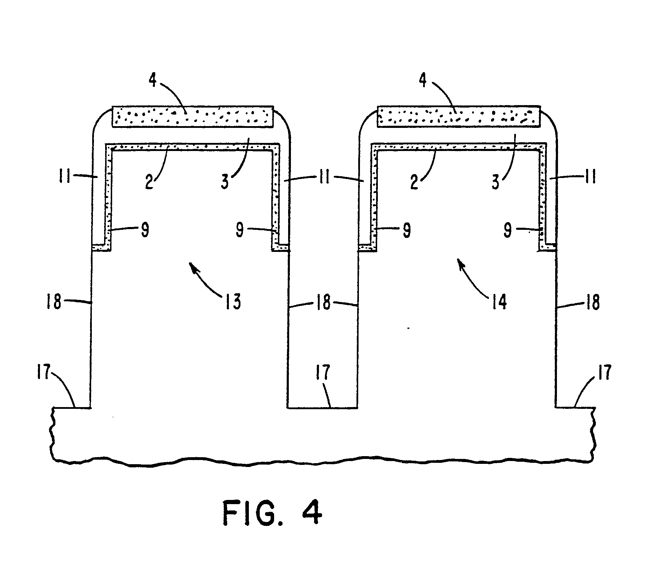

As shown in Fig. 4, the silicon islands at 13 and 14 are not only capped with oxide, nitride and PAD oxide layers 2, 3, 4, 9 and 11, but are elevated from silicon substrate surface 17 to expose lateral walls 18 of underlying silicon to subsequent process ambients.

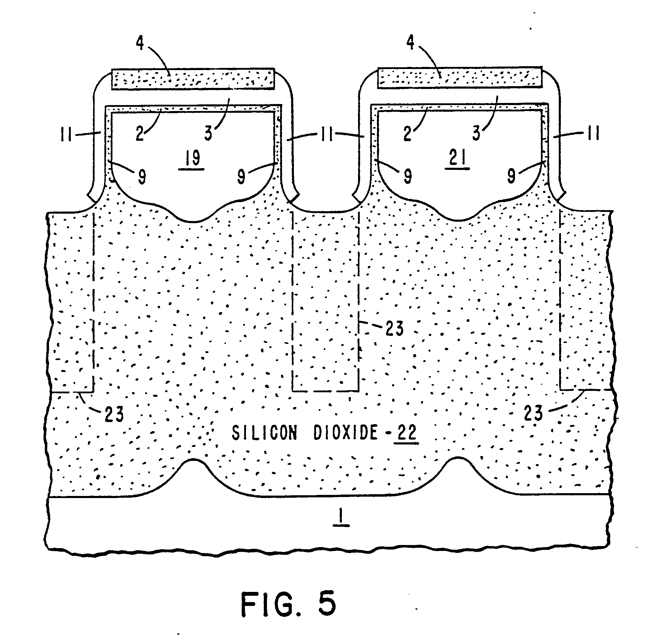

The structure depicted in Fig. 4 is thereafter subjected to a thermal oxidation step. The oxidation replaces selected regions of substrate silicon with oxide in the course of forming electrically isolated islands of monocrystalline silicon. The outcome of the preferred process is illustrated in Fig. 5, where silicon islands 19 and 21 are formed and isolated from substrate silicon 1 by oxide 22. Though the oxidation process consumes some of the lower island silicon, and slightly lifts the lower edges of the nitride caps, the silicon at the top of each island remains intact. In this manner, the upper surface perimeter of each island remains in precise correspondence to the pattern established in masking nitride 2.

Dashed lines 23 depict the general outline of the structure before oxidation. The voids in the silicon substrate are filled during the oxidation by the 2:1 volumetric increase in material when monocrystalline silicon is converted to silicon dioxide. Note that the oxidation also penetrates downward into substrate 1. The magnitude of the oxidation beneath each island ensures not only consistent and reliable dielectric isolation of islands 19 and 21 but also provides adequate dimensional separation to completely eliminate electric field coupling between substrate 1 and islands 19 and 21.

An ambient suitable to perform the thermal oxidation prescribed above involves an $O_2$ plus $H_2O$ (gas) environment at 950—1100 degrees C for 10—20 hours.

With the islands formed, and separating dielectric in place, the wafer is subjected to an oxide and nitride strip operation. Preferably, the strip operation is comprised of a deglaze with buffered HF to remove layer 4 and an etch with hot $H_3PO_4$ to remove residuals of nitride capping layers 3 and 11.

Planarization of the mesa structure follows. Initially a plasma enhanced CVD oxide 24, as shown in Fig. 6, is applied to form a layer 120 nanometers thick over oxide 22 and monocrystalline silicon islands 19 and 21. The important process constraint at this stage of the fabrication is to ensure that the thickness of deposited oxide 24 reaches level 26, which is nominally at least 10 nanometers above plateau level 27 of silicon islands 19 and 21. It should be understood that the magnitude of this difference in levels is influenced by considerations such as the etching uniformity, the planarization efficacy, and the uniformity in the thickness of oxide 24. The impact of these factors will be more fully appreciated upon considering the concluding steps in the composite process.

With the deposited oxide 24 in place, planarization continues with the application of a low molecular weight, low surface tension polymer solution, such as polymethylmethacrylate or polystyrene, to the wafer surface. This may be accomplished by spin coating the wafer with a solution of the composition. To ensure that the polymer reflows and planarizes during baking, the polymer composition and temperature should be selected so that the molten polymer has both a viscosity below 5 centistokes and a relatively low surface tension. Coating and baking steps may be repeated until the desired degree of surface planarization is achieved. In Fig. 6, the polymer composition is shown at 28.

The polymer planarized wafer is then subjected to a pair of etching steps, steps suitable to expose silicon islands 19 and 21 while maintaining a uniform surface plane with the surrounding dielectric. The wafer is first subjected to RIE 29. The etch parameters are chosen to remove polymer 28 and oxide 24 at a substantially equal rate. Thereby, when the etch descends to a level between 26 and 27 the wafer surface is substantially planar and yet absent of all polymer. The etch process may be monitored for polymer residuals to establish an end point for the first segment of the etch sequence. A suitable set of conditions for performing this etch includes the use of an Applied Materials AM-8110 reactor with the parameters appearing in Table E.

### TABLE E

Gas and flow: $CHF_3$ at 30—70 $cm^3$/min
$+O_2$ at 30—70 $cm^3$/min.
Pressure: 8.0 Pa (60 mTorr).
Power: 1200 Watts.

It will no doubt be recognized that the exact parameters are intimately related to the chemical composition of the selected polymer and, therefore, can only be established by particularized tests. Nonetheless, the underlying objectives remain intact. Namely, to adjust the reaction rates of $O_2$ and $CHF_3$ with polymer and $SiO_2$ to remove both materials from the wafer surface at substantially equal rates.

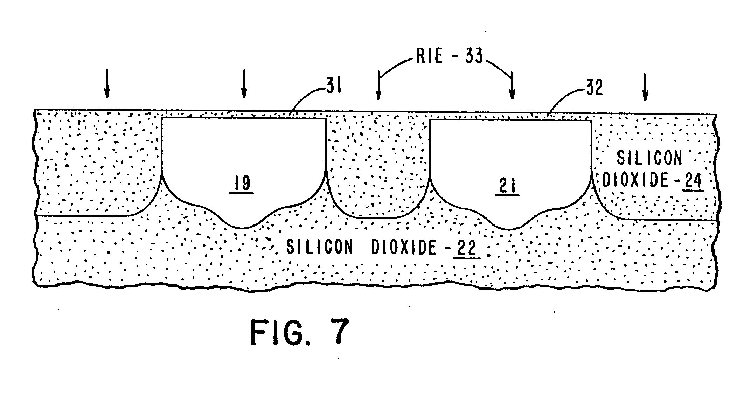

At the conclusion of RIE 29 the surface appears as shown in Fig. 7. The purpose for the oxide between levels 26 and 27 in Fig. 6 is now apparent. Thin oxide layers 31 and 32, over respective silicon islands 19 and 21, allow sufficient overetching of oxide to ensure the complete removal of polymer 28 without subjecting the silicon itself to the etching of RIE 29. Furthermore, residuals of oxide layers 31 and 32 are excellent protective masks for any in-process handling and storage of the wafers.

Fabrication of the islands is concluded with RIE 33. In this etch, the parameters are selected to ensure that oxide 24 and silicon 19 and 21 are etched at substantially identical rates. A suitable set of conditions for the above-noted AM-8110 reactor are presented in Table F.

### TABLE F

Gas and flow: $CHF_3$ at 75 $cm^3$/min+
$O_2$ at 40—50 $cm^3$/min.
Pressure: 8.6 Pa (65 mTorr).
Power: 1200 Watts.

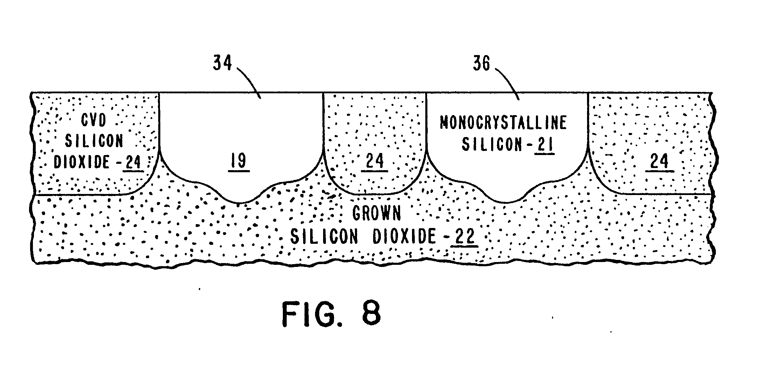

Upon completing the etch of the wafer in Fig. 7 to remove oxides 31 and 32, the structure appears as depicted in Fig. 8. Note that surfaces 34 and 36 are coplanar with surrounding oxide regions 24, that monocrystalline silicon islands 19 and 21 are electrically isolated from the substrate silicon by oxide 22, and that islands 19 and 21 retain the original crystallinity quality of the substrate silicon. It should also be appreciated that silicon islands 19 and 20 have precisely defined perimeter lines, are relatively wide in dimension, and lie in close proximity to each other. These latter features provide for efficient utilization of chip area.

In considering the process as a whole, note that the structural features enumerated above are achieved with a single masking operation and a sequence of steps which are relatively insensitive to process variables. In that regard, critical fabrication steps are expressly avoided.

It should be understood and appreciated that the operations performed in the sequence of steps depicted from Fig. 1 to Fig. 5 may conclude with the stripping of the silicon cap shown in Fig. 5. Though the wafer topology would not be planarized, active devices can be created in the silicon islands as formed.

**Claims**

1. A process for fabricating silicon-on-insulator structures on a semiconductor wafer, including the sequential steps of: anisotropically etching into a silicon substrate (1) to form islands (13, 14) of silicon; capping the tops and sides of the silicon islands (13, 14) with masks; anisotropically etching deeper into the silicon substrate between the capped silicon islands (13, 14) to increase the relative height of the silicon islands (13, 14); and oxidizing exposed silicon not covered by said masks until the capped silicon islands (13, 14) are electrically isolated from the silicon substrate (1) thereby forming electrically isolated silicon islands (19, 21).

2. A process according to claim 1, characterized by the further successive steps of depositing a dielectric layer (24) over and between the electrically isolated silicon islands (19, 21) to a thickness greater than the height of the electrically isolated silicon islands (19, 21); forming a planarized polymer layer (28) over the dielectric layer; simultaneously etching the polymer (28) and dielectric (24) layers to remove polymer and dielectric material at substantially equal rates until the polymer layer (28) is absent; and simultaneously etching the dielectric layer (24) and the electrically isolated silicon to remove dielectric material and silicon at substantially equal rates.

3. A process according to claim 2, characterized in that said step of forming a planarized polymer layer (28) over the dielectric layer (24) includes depositing and reflowing polystyrene or polymethylmethacrylate.

4. A process according to claim 3, characterized in that said step of depositing a dielectric layer (24) includes a plasma enhanced chemical vapor deposition of silicon dioxide.

5. A process according to claim 4, characterized in that said step of depositing a dielectric layer (24) is preceded by the step of stripping the capping material from the electrically isolated silicon islands (19, 21).

6. A process according to claim 5, characterized in that said step of oxidizing exposed silicon includes thermal oxidation to grow silicon dioxide (22) to the level of the capped silicon.

7. A process according to claim 6, characterized in that said step of capping the tops and sides of the silicon islands (13, 14) includes: forming a silicon nitride layer (11) over silicon islands (13, 14) already having an intermediate oxide layer (2), a silicon nitride layer (3) and a silicon dioxide layer (4) successively formed on the tops thereof;

and anisotropically etching the silicon nitride layer (11) to expose the silicon dioxide (4) on the tops of the silicon islands (13, 14) and the silicon substrate (1) between the silicon islands (13, 14).

**Patentansprüche**

1. Ein Verfahren zum Herstellen von Siliziumauf-Isolator-Strukturen auf einem Halbleiterplättchen mit den aufeinanderfolgenden Schritten: Anisotropes Ätzen in das Siliziumsubstrat (1), um Inseln (13, 14) aus Silizium zu bilden; Überdecken der Oberseiten und Seiten der Siliziuminseln (13, 14) mit Masken; Anisotropes Ätzen tiefer in das Siliziumsubstrat zwischen den abgedeckten Siliziuminseln (13, 14), um die relative Höhe der Siliziuminseln (13, 14) zu vergrößern; und Oxidieren von freiliegendem Silizium, das nicht durch die Masken abgedeckt ist, bis die überdeckten Siliziuminseln (13, 14) elektrisch von dem Siliziumsubstrat (1) isoliert sind, so daß elektrisch isolierte Siliziuminseln (19, 21) gebildet werden.

2. Verfahren nach Anspruch 1, gekennzeichnet durch die weiteren aufeinanderfolgenden Schritte: Ablagern einer dielektrischen Schicht (24) über und zwischen den elektrisch isolierten Siliziuminseln (19, 21) bis zu einer Dicke größer als die Höhe der elektrisch isolierten Siliziuminseln (19, 20); Bilden einer planarisierten Polymerschicht (28) über der dielektrischen Schicht; gleichzeitiges Ätzen der polymeren (28) und dielektrischen (24) Schichten, um polymeres und dielektrisches Material mit im wesentlichen gleichen Geschwindigkeiten zu entfernen, bis die Polymerschicht (28) entfernt ist; und gleichzeitiges Ätzen der dielektrischen Schicht (24) und des elektrisch isolierten Siliziums, um dielektrisches Material und Silizium mit im wesentlichen gleichen Geschwindigkeiten zu entfernen.

3. Verfahren nach Anspruch 2, dadurch gekennzeichnet, daß der Schritt Bilden einer planarisierten Polymerschicht (28) über der dielektrischen Schicht (24) Ablagern und Rückfließen von Polystyrol oder Polymethylmethacrylat einschließt.

4. Verfahren nach Anspruch 3, dadurch gekennzeichnet, daß der Schritt Ablagern einer dielektrischen Schicht (24) eine plasmaunterstütze chemische Dampfablagerung von Siliziumdioxid einschließt.

5. Verfahren nach Anspruch 4, dadurch gekennzeichnet, daß vor dem Schritt Ablagern einer dielektrischen Schicht (24) der Schritt Abstreifen des überdeckenden Materials von den elektrisch isolierten Siliziuminseln (19, 21) vorangeht.

6. Verfahren nach Anspruch 5, dadurch gekennzeichnet, daß der Schritt Oxidieren von freiliegendem Silizium eine thermische Oxidation einschließt, um Siliziumdioxid (22) zur Höhe des überdeckten Siliziums aufzuwachsen.

7. Verfahren nach Anspruch 6, dadurch gekennzeichnet, daß der Schritt Überdecken der Oberseiten und Seiten der Siliziuminseln (13, 14) einschließt: Bilden einer Siliziumnitridschicht (11) über den Siliziuminseln (13, 14), die bereits eine Oxidzwischenschicht (2), eine Siliziumnitridschicht (3) und eine Siliziumdioxidschicht (4) aufweisen, die aufeinanderfolgend jeweils darüber gebildet wurden; und anisotropes Ätzen der Siliziumnitridschicht (11), um das Siliziumdioxod (4) an den Oberseiten der Siliziuminseln (13, 14) und das Siliziumsubstrat (1) zwischen den Siliziuminseln (13, 14) freizulegen.

## Revendications

1. Procédé de production de structures silicium-sur-isolant sur une tranche semi-conductrice, comprenant les étapes successives consistant: à soumettre un substrat de silicium (1) à une gravure anisotrope pour former des îlots (13, 14) de silicium; à coiffer les sommets et les côtés des îlots de silicium (13, 14) avec des masques; à soumettre le substrat de silicium à une gravure anisotrope plus en profondeur entre les îlots de silicium (13, 14) munis d'une coiffe, pour accroître la hauteur relative des îlots de silicium (13, 14); et à oxyder le silicium à nu, non recouvert par lesdits masques, jusqu'à ce que les îlots de silicium (13, 14) munis d'une coiffe soient électriquement isolés du substrat de silicium (1), en formant ainsi des îlots de silicium électriquement isolés (19, 21).

2. Procédé suivant la revendication 1, caractérisé en ce qu'il comprend les étapes successives supplémentaires consistant: à déposer une couche diélectrique (24) sur et entre les îlots de silicium électriquement isolés (19, 21) à une épaisseur supérieure à la hauteur des îlots de silicium électriquement isolés (19, 21); à former une couche de polymère rendue plane (28) sur la couche diélectrique; à soumettre simultanément la couche polymérique (28) et la couche diélectrique (24) à une gravure pour éliminer le polymère et la matière diélectrique à des vitesses pratiquement égales jusqu'à suppression de la couche de polymère (28); et à soumettre simultanément la couche diélectrique (24) et le silicium électriquement isolé à une gravure pour éliminer la matière diélectrique et le silicium à des vitesses pratiquement égales.

3. Procédé suivant la revendication 2, caractérisé en ce que l'étape de formation d'une couche de polymère rendue plane (28) sur la couche diélectrique (24) comprend un dépôt et une refusion de polystyrène ou de polyméthacrylate de méthyle.

4. Procédé suivant la revendication 3, caractérisé en ce que l'étape de dépôt d'une couche diélectrique (24) comprend un dépôt de vapeur chimique, renforcé par plasma, de dioxyde de silicium.

5. Procédé suivant la revendication 4, caractérisé en ce que l'étape de dépôt d'une couche diélectrique (24) est précédée par l'étape d'élimination de la matière de formation de coiffe des îlots de silicium électriquement isolés (19, 21).

6. Procédé suivant la revendication 5, caractérisé en ce que l'étape d'oxydation du silicium mis à nu comprend une oxydation thermique pour faire croître du dioxyde de silicium (22) au niveau du silicium muni d'une coiffe.

7. Procédé suivant la revendication 6, caractérisé en ce que l'étape consistant à coiffer les sommets et les côtés des îlots de silicium (13, 14) consiste: à former une couche de nitrure de silicium (11) sur les îlots de silicium (13, 14) portant déjà une couche intermédiaire d'oxyde (2), une couche de nitrure de silicium (3) et une couche de dioxyde de silicium (4) formées successivement sur leurs sommets; et à soumettre à une gravure anisotrope la couche de nitrure de silicium (11) pour mettre à nu le dioxyde de silicium (4) sur les sommets des îlots de silicium (13, 14) et le substrat de silicium (1) entre les îlots de silicium (13, 14).

## FIG. 1

RIE - 8

6 — PR 7

4 — SILICON DIOXIDE

2 — SILICON NITRIDE — 3

MONOCRYSTALLINE SILICON   1

## FIG. 2

RIE - 12

## FIG. 3

RIE - 16

FIG. 4

FIG. 5

# FIG. 6

RIE - 29

POLYMER - 28

SILICON
DIOXIDE - 24

26

27

SILICON - 19

SILICON - 21

SILICON DIOXIDE - 22

EP 0 146 613 B1

RIE - 33

31

32

SILICON
DIOXIDE - 24

19

21

SILICON DIOXIDE - 22

FIG. 7

34    36

CVD
SILICON
DIOXIDE - 24    19    24    MONOCRYSTALLINE
SILICON - 21    24

GROWN
SILICON DIOXIDE - 22

## FIG. 8